# EUROPEAN PATENT APPLICATION

(11) **EP 1 313 223 A1**
(43) Date of publication of application: **21.05.2003**
(21) Application number: 02023187.4
(22) Date of filing: 16.10.2002
(51) Int. Cl.: H03K 17/97, G01D 5/14

(54) **High-sensitivity magnetic sensor**

(30) Priority: 19.11.2001 IT PN20010083
(71) Applicant: STEM S.r.l., 27010 Cura Carpignano (Pavia) (IT)
(72) Inventor: Moro, Simone, 27100 Pavia (IT); Moro, Fabio, 27100 Pavia (IT)
(74) Representative: Giugni, Valter

(57) **Abstract**

High-sensitivity magnetic proximity sensor adapted to cooperate with an activating magnet (14) to the purpose of controlling moving apparatuses, such as lifts, elevators and similar equipment.

The sensor essentially comprises an integrated Hall-effect micro-circuit (10) that is mounted on a printed-circuit board (12) along with a polarization magnet (11), so as to enable the magnetic flux of the a polarization magnet to combine with the magnetic flux of the activating magnet, wherein the sensor is mechanically disjoined from the latter.

The solution is extremely simple and highly reliable as far as both the speed of response and the level of sensitivity are concerned.

## Description

The present invention refers to a high-sensitivity magnetic proximity sensor, which is suitable for use in control applications concerning a wide range of apparatuses, in particular lifts, elevators and the like.

A well-known device used to control the motions, i.e. the displacement and the positions of such apparatuses is based on the use of a reed phial, which is substantially constituted by a glass tube containing an electric contact, said reed phial being normally in a resting condition and being adapted to be switched over to an operating condition when a magnetic body is coming close to the sensor. Sensors of this kind, however, are only suitable for use in conjunction with apparatuses whose displacement speed does not exceed a certain value, eg. 1.5 m/s. In fact, a reed phial is not capable of detecting a signal delivered by a magnet which, owing to the moving speed of the apparatus, is only able to dwell in front of the sensor for very short a period of time.

In order to enable magnetic proximity sensors to be used also in conjunction with apparatuses that move at quite high displacement speeds, such as for instance lifts installed in high-rise buildings including various dozens of storeys, a fork-shaped sensor has been proposed, in which both the reed contact and the magnet are integrated into a single structure featuring a recess in which a metal blade is able to slide. Such sensors are situated at each storey or floor in the building and, when the metal blade is not there, i.e. is absent, they issue a continuous signal (the contact is normally kept closed by the flux of the magnet). The metal blade is fixed on to the lift cage in such a manner as to be able to slide in the recess of the fork-like sensor assembly when the cage passes by the sensor. The task performed by said metal blade consists in cutting out the magnetic flux and, as a result, causing the contact of the sensor to open. The length of this metal blade is selected in such a manner as to ensure that, notwithstanding the speed at which the lift cage may also be moving, the flux of the magnet is cut out for a period of time that is adequately long to ensure that the signal issued by the sensor is cut off.

Anyway, such a control system based on the use of these fork-shaped structures is critical from a mechanical point of view, since it requires quite accurate a coupling, i.e. matching of the sensor with the metal blade. The latter, however, moves at a high displacement speed jointly with the lift cage and is therefore subject to marked vibrations and oscillations, so that a real risk exists that, owing to a particularly strong oscillation, a collision may occur between the blade and the sensor, under a resulting breakdown of the latter.

In view of enabling apparatuses moving at high displacement speeds to be adequately controlled, the use has also been proposed of sensors based on the Hall effect, i.e. on the transverse-potential difference between the opposite faces of a conductor , which is proportional to the density of the electric current flowing therethrough and the magnetic field in which it is placed (according to a coefficient that depends on the nature of the material). The system is based on the utilization of a multiplicity of Hall effects within a single sensor. This system turns out to be advantageous owing to the speed of response of the signal and the accuracy thereof; it however has a major drawback in the poor sensitivity thereof. In order to increase such a sensitivity, the need arises for the magnets to be securely close to the sensor when it finds itself in the suitable position. To this purpose, the magnets, which must be provided at each floor of the building, are attached on to a flexible support resembling a band or strip, which is anchored at the base of the lift and is as long as the height that the apparatus is intended to cover. The sensor, arranged on the lift cage, is provided at the sides with swallowtail-shaped contours that constrain the flexible support to pass near the same sensor. As in the case of the afore cited fork-shaped sensors, also this solution requires a mechanical coupling of the sensor with the support on which the magnets are fixed. The afore exposed drawbacks therefore remain practically unaltered, while a further complication is at the same time added to the construction of the whole apparatus, owing to the need for the support to be anchored at the base of the lift, to be stretched out over quite a considerable length, and to be reliably caused to pass between the swallowtail-shaped contours of the sensors.

It therefore is a main purpose of the present invention to provide a Hall-effect magnetic proximity sensor which ensures a full mechanical independence of the sensor from the related activating magnet, so as to allow for an extremely simple and practical application thereof, similar to the application of traditional sensors, while anyway ensuring a fully reliable operation as far as the accuracy and speed of response and the sensitivity level are concerned.

According to the present invention, these and further aims are reached in a high-sensitivity magnetic proximity sensor embodying the characteristics as recited and defined in the appended claims.

Anyway, features and advantages of the present invention will be more readily understood from the description that is given below by way of nonlimiting example with reference to the accompanying drawings, in which:
- Figures 1A and 1B are sectional views, along mutually orthogonal planes, of the basic elements of the sensor according to the present invention;
- Figure 2 is a schematic perspective view of an arrangement with assembled sensor according to the present invention; and
- Figure 3 is a partially perspective view of an example of installation of the sensor according to the present invention, with an enlarged detail for greater visibility thereof.

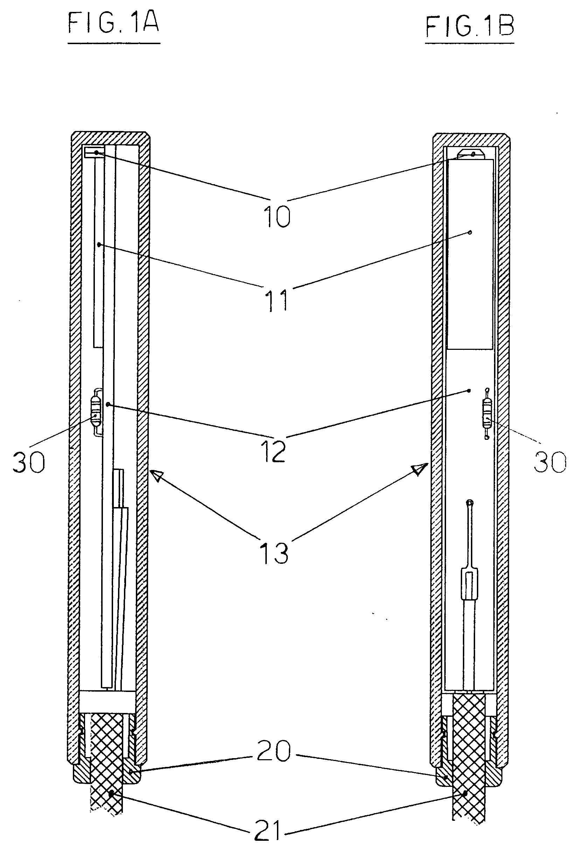

The magnetic proximity sensor covered by the present invention is substantially constituted by an integrated Hall-effect micro-circuit 10, which is mounted, along with a polarization magnet 11, on a printed-circuit board 12 (Figures 1A and 1B).

As generally known, the integrated Hall-effect micro-circuit 10 is a switch activated by a magnetic field, which uses a Hall generator, a trigger circuit and a transistor amplifier. The Hall generator gives an output voltage proportional to the strength of the magnetic field.

The polarization magnet 11 is suitably made in the form of a plastoferrite chip featuring an alternate sequence of SOUTH-NORTH-SOUTH polarities on a side and NORTH-SOUTH-NORTH polarities on the other side.

According to the present invention, the integrated micro-circuit 10 and the polarization magnet 11 are mounted on the back face of the printed-circuit board 12, i.e. on the surface thereof which is opposite to the one carrying the conductive paths. Furthermore, the integrated micro-circuit 10 is mounted at a right angle with respect to the surface of the board 12 and the polarization magnet is in contact with the integrated micro-circuit 10.

In an advantageous manner, a resistor 30 is included on the board 12 in order to protect the integrated micro-circuit 10 against pole inversions in the power supply of the sensor.

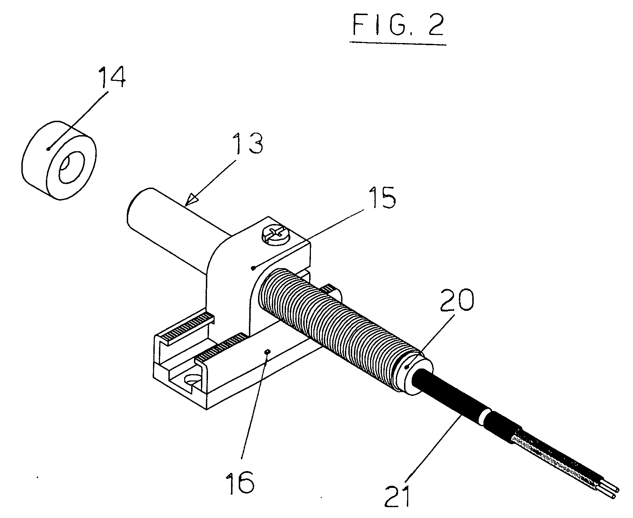

The described constructional solution, which is the result of in-depth research activities and related experimental and testing work, makes it possible for a sensor 13 to be provided in the form of both a bistable sensor and a simple-contact sensor. The first type of sensor, i.e. the bistable one, maintains the signal it acquires when it passes in front of a polarity of an activating magnet 14, and eventually releases it, de-activating itself, when it encounters an opposite polarity with respect to the former one (Figure 2). The second type of sensor, on the contrary, delivers the signal throughout the sole period of time during which the activating magnet 14 dwells within the sensitive zone of the sensor 13.

The particular configuration of the polarization magnet 11 generates a magnetic flux that has the same direction as the magnetic flux generated by the activating magnet 14, however with a lower strength than necessary to activate the integrated micro-circuit 10. As a result, a task assigned to the polarization magnet 11 is to generate a magnetic flux that adds up to the magnetic flux of the activating magnet 14, so that the latter is enabled to perform its task even if it is positioned at a certain distance from integrated micro-circuit 10.

If the polarization magnet 11 is given an opposite configuration with respect to the previously described one, the magnetic flux generated by it would still follow the same direction as, but in the opposite way with respect to the flux generated by the activating magnet 14. In this case, the resulting flux would amount to the difference of the fluxes of the two magnets and, as a result, the sensitivity of the sensor would be reduced.

The characteristics of the plastoferrite magnet 11 shall therefore be such as to enable a compromise solution to be reached, as imposed by the operating needs in view of favouring the activation of the integrated Hall-effect micro-circuit 10, while enabling such an activation solely in the presence of also the activating magnet 14.

The assembly 13, constituted by the integrated micro-circuit 10, the polarization magnet 11 and the printed-circuit board 12, *with the related resistor 30,* is inserted in a preferably cylindrical case that is filled with resin to obtain the necessary electric insulation. The case is sealed with a cap 20 provided with a sealing grommet for the power supply cable 21 (Figure 2) to pass out therethrough. A sensor is obtained in this manner which has a configuration that is very similar to that of traditional sensors, and which can be installed in a simple and reliable manner, however mechanically separated from and unconstrained by the activating magnet 14 all the way, exactly according to the actual purpose of the present invention.

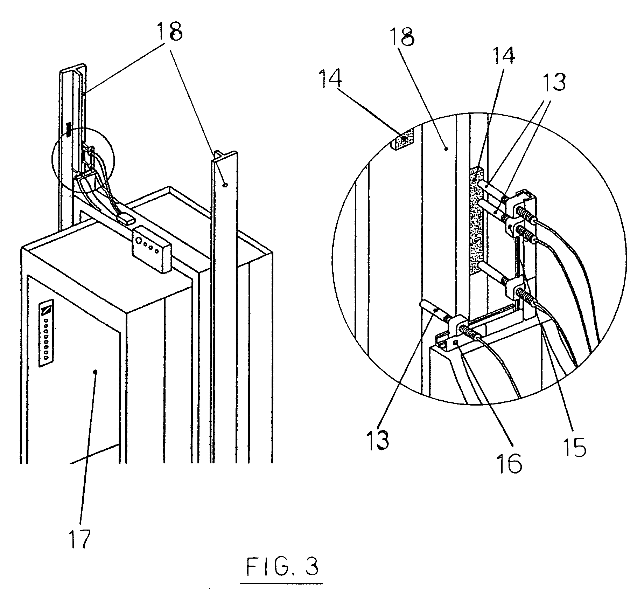

The case of the sensor 13 has a knurled outer surface and is attached by means of a screw-tightened clamp 15, the position of which may be adjusted along a support 16 that is mounted on the apparatus to be controlled, such as for instance the cage 17 of a lift (Figure 3). As this can be more readily inferred from the enlarged detail appearing in Figure 3, a plurality of sensors 13 are normally used, which are adapted to cooperate with corresponding magnets attached to the guide profiles 18 of the cage 17 of the lift.

## Claims

1. High-sensitivity magnetic proximity sensor adapted to cooperate with an activating magnet (14) to the purpose of controlling moving apparatuses, said sensor comprising a case in which there is inserted an integrated Hall-effect micro-circuit (10) that is mounted on a printed-circuit board (12) connected to an electric cable coming out of the same case through a sealing cap thereof, **characterized in that** said sensor (13) is mechanically disjoined from said activating magnet (14) and a polarization magnet (11) is mounted on said printed-circuit board (12) in contact with said integrated micro-circuit (10), in which said polarization magnet (11) is adapted to generate a magnetic flux that combines with the magnetic flux generated by said activating magnet (14).

2. Magnetic proximity sensor according to claim 1, **characterized in that** said integrated micro-circuit (10) is mounted at a right angle with respect to the printed-circuit board (12) on the back surface thereof, along with the polarization magnet (11).

3. Magnetic proximity sensor according to claim 1 or 2, **characterized in that** said polarization magnet (11) is made in the form of a plastoferrite chip featuring an alternate sequence of SOUTH-NORTH-SOUTH polarities on a side and NORTH-SOUTH-NORTH polarities on the opposite side.

4. Magnetic proximity sensor according to any of the preceding claims, **characterized in that** the magnetic fluxes generated by the polarization magnet (11) and the activating magnet (14) follow the same direction in the same way or in a mutually opposing way.

5. Magnetic proximity sensor according to any of the preceding claims, **characterized in that** a resistor (30) is included on the printed-circuit board (12) as a protection for the integrated micro-circuit (10).
